# EUROPEAN PATENT SPECIFICATION

(11) **EP 4 177 913 B1**
(45) Date of publication and mention of the grant of the patent: **02.12.2026**
(21) Application number: 22205533.7
(22) Date of filing: 04.11.2022
(51) Int. Cl.: H01F 3/10, H01F 17/06, H01F 27/25, H01F 27/255, H01F 27/26, H01F 27/28

(54) **MAGNETIC ELEMENT AND ELECTRONIC DEVICE**
MAGNETISCHES ELEMENT UND ELEKTRONISCHE VORRICHTUNG
ÉLÉMENT MAGNÉTIQUE ET DISPOSITIF ÉLECTRONIQUE

(30) Priority: 04.11.2021 CN 202111299457
(43) Date of publication of application: 10.05.2023
(73) Proprietor: Huawei Digital Power Technologies Co., Ltd., Shenzhen, 518043 (CN)
(72) Inventor: BI, Jianguo, Shenzhen, 518043 (CN)
(74) Representative: MERH-IP Matias Erny Reichl Hoffmann Patentanwälte PartG mbB

(56) References cited:
- EP-A1- 0 794 539
- CN-A- 102 368 424
- CN-B- 106 158 225
- CN-U- 208 922 882
- JP-A- 2000 228 319
- US-A1- 2007 257 759
- US-A1- 2018 204 669
- US-A1- 2020 312 515

## Description

### TECHNICAL FIELD

This application relates to a magnetic element and an electronic device.

### BACKGROUND

With the development of modern science, various electronic and electrical devices provide high efficiency for social production, and greatly facilitate people's daily life. At the same time, electromagnetic interference and radiation generated in a working process of the electronic and electrical devices affects people's life and production, and leads to deterioration in an electromagnetic environment of human living space. A magnetic element is used in an electronic device, has a filtering function, can filter an electromagnetic interference signal, and can suppress outward radiation and emission of an electromagnetic wave generated by a high-speed signal cable. How to design a magnetic element for which not only a volume and costs of the magnetic element can be controlled but common-mode impedance of the magnetic element can also be increased is a research direction in the industry. Document US 2020/312515 A1 generally discloses an inductor that comprises: a first magnetic body having a toroidal shape, and including a ferrite; and a second magnetic body disposed on an outer circumferential surface or an inner circumferential surface of the first magnetic body, wherein the second magnetic body includes: resin material and a plurality of layers of metal ribbons wound along the circumferential direction of the first magnetic body, wherein the resin material comprises a first resin material disposed to cover an outer surface of the plurality of layers of metal ribbons, and a second resin material disposed in at least a part of a plurality of layers of interlayer spaces.
Document CN 106 158 225 B generally relates to a high and low pass combined filter magnetic core, electrical apparatus element and electrical equipment. The high and low pass combined filter magnetic core comprises a first magnetic medium and a second magnetic medium which are different in type, the mechanical strength of the first magnetic medium is higher than that of the second magnetic medium, and the second magnetic medium is embedded in the first magnetic medium and wrapped by the first magnetic medium to achieve full-band filtering. The magnetic media of two different types are assembled together through an existing forming technical scheme to achieve full-band filtering, the use space and tedious process are reduced, the winding labor hour is greatly shortened, and production efficiency is improved.
Document EP 0 794 539 A1 generally discloses a choke coil that has a magnetic core made up of two weakly magnetic materials of different permeability and saturation induction. A ring shaped disk is placed on at least one end of a ring core. The latter is formed of a stack of disks or from a wound strip of weakly magnetic material. The ring shaped disk is made up of compressed flakes of amorphous or nanocrystalline alloys with addition of plastic binder. A ring shaped disk of compressed flakes may be fixed to each end of the ring core of weakly magnetic material. The choke coil may be connected in series with a load and a control device operating according to the phase splitting process. The flakes may be arranged in the disk such that the length of the flakes runs in the direction of the flux.
Document JP 2000 228319 A generally discloses a small-sized chock coil, wherein a magnetic core is composed by combining a nanocrystal soft magnetic alloy core made into a toroidal shape of a nanocrystal soft magnetic alloy, in which nanocrystal grains whose crystal grain diameters are 50 nm or smaller occupy 50% or more of the whole volume of its structure, and a ferrite core made of ferrite into a toroidal shape to be coaxial, and lead wires are wound about the magnetic core.
Document CN 102 368 424 A generally discloses a magnetic core for an inductor, which comprises three magnetic cores, i.e. a circular magnetic core (1), a circular magnetic core (2') and a circular magnetic core (1'); the circular magnetic core (1) is provided with a circular groove (2) on one surface; the circular magnetic core (1') is provided with a circular groove (2") on one surface; the circular magnetic core (2') is arranged in the circular groove (2) of the circular magnetic core (1); the circular magnetic core (1') is covered on the circular magnetic core (1); the circular magnetic core (1) and the circular magnetic core (1') enclose the circular magnetic core (2') inside; and the axes of the circular magnetic core (1), the circular magnetic core (2') and the circular magnetic core (1') are maintained coincidence and are bonded by binder to form a complete composite circular magnetic core.
Document CN 208 922 882 U generally discloses a common-mode inductor that comprises a magnetic core and at least two magnetic induction coils, wherein the at least two magnetic induction coils are wound on the magnetic core; wherein the numbers of turns and phases of two adjacent magnetic induction coils are the same; the common-mode inductor further comprises an auxiliary magnet, and the auxiliary magnet is arranged between every two adjacent magnetic induction coils.

### SUMMARY

Embodiments of this application provide a magnetic element and an electronic device. In particular, embodiments of the present application are defined by the independent claims. Additional features of embodiments of the invention are presented in the dependent claims. In the following, parts of the description and drawings referring to former embodiments which do not necessarily comprise all features to implement embodiments of the claimed invention are not represented as embodiments of the invention but as examples useful for understanding the embodiments of the invention. Embodiments of the present application (or the present disclosure) provide a magnetic element and an electronic device.

According to a first aspect, an implementation of this application provides a magnetic element. The magnetic element is used in an electronic device, and is configured to suppress outward radiation of an electromagnetic wave generated by a high-speed signal cable in the electronic device. The magnetic element includes a composite magnetic core and a winding, the composite magnetic core includes an internal magnet and an external magnetic shell, the internal magnet is formed by winding a strip material, the external magnetic shell partially or entirely covers a periphery of the internal magnet, the external magnetic shell is fixedly connected to the internal magnet, the winding is wound on an outer surface of the external magnetic shell, the external magnetic shell is configured to protect the internal magnet from pulling force in a process of winding the winding, and the external magnetic shell is configured to increase common-mode impedance of the magnetic element.

For the internal magnet formed by winding the strip material, a coil cannot be directly wound on an outer surface of the internal magnet, because pulling stress acting on a surface of the internal magnet may be generated in a process of winding the coil, and the stress may destroy the internal magnet and affect a filtering function of the magnetic element. Because the external magnetic shell in the composite magnetic core provided in this application has a magnetic material, as a protective shell covering the periphery of the internal magnet, the external magnetic shell can not only protect the internal magnet from pulling stress in a wire winding process, but also improve the filtering function of the magnetic element. The external magnetic shell in the composite magnetic core has the magnetic material, and the winding is wound on an outer surface of the external magnetic shell. The external magnetic shell has a function of filtering electromagnetic noise, so that the filtering effect of the magnetic element can be improved. If the external magnetic shell has no magnetic material, but has only a function of protecting the internal magnet, and the external magnetic shell is made of a non-magnetic material, such an external magnetic shell in the composite magnetic core cannot participate in the filtering function of the magnetic element. If the external magnetic shell occupies space of the composite magnetic core but has no filtering function, this is not conducive to a miniaturization design of the magnetic element, and consequently, a volume and costs of the magnetic element are increased.

In a possible implementation, a material of the external magnetic shell includes at least one of ferrite or alloy magnetic powder. In this solution, the material of the external magnetic shell is specifically limited. The external magnetic shell may be a single material, or may be formed by combining a plurality of materials.

In a possible implementation, a material of the internal magnet includes at least one of amorphous alloy or nanocrystalline. In this solution, the material of the internal magnet is limited, and may be a single material (an amorphous material or a nanocrystalline material), or may be a combination of an amorphous material and a nanocrystalline material.

In a possible implementation, a material of the internal magnet is a nanocrystalline strip material, and a material of the external magnetic shell is ferrite. In this solution, the material of the internal magnet and the material of the external magnetic shell are limited, and the internal magnet of the nanocrystalline strip material and the external magnetic shell of the ferrite are combined in one composite magnetic core, so that performance of a common-mode inductor can be improved while a volume and costs of the composite magnetic core are properly controlled. In this way, not only the magnetic element has a relatively good filtering effect, but overall performance of the magnetic element can also be improved in a design condition that a relatively small volume and relatively low costs are controlled.

In a possible implementation, a material of the internal magnet is a nanocrystalline strip material, and a material of the external magnetic shell is a combination of manganese zinc ferrite, nickel zinc ferrite, and alloy magnetic powder. In this solution, the material of the internal magnet and the material of the external magnetic shell are limited, and the internal magnet of the nanocrystalline strip material matches the external magnetic shell made of the combined material, so that wideband (150 kHz to 300 MHz) filtering can be implemented. In other words, in this solution, a frequency range of an electromagnetic filtering signal filtered by the magnetic element is relatively wide, and may be 150 kHz to 300 MHz. In this solution, the volume and the costs of the magnetic element can also be reduced. A filtering range of a magnetic element in a conventional technology is (150 kHz to 30 MHz, or 30 MHz to 300 MHz). Compared with the conventional technology, filtering bandwidth is widened in this application.

According to the invention as claimed, the external magnetic shell includes a first shell and a second shell, and the first shell and the second shell are connected and jointly surround the internal magnet. In this solution, the external magnetic shell is designed as two parts: the first shell and the second shell, and the first shell and the second shell are connected and jointly surround the internal magnet, so that manufacturing costs of this solution are relatively low, and this helps reduce costs of the magnetic element.

According to the invention as claimed, the first shell forms first space, the second shell forms second space, the first space and the second space are connected to each other and jointly accommodate the internal magnet, and a gap is disposed between the internal magnet and an inner surface of the external magnetic shell. Advantages of this solution are: Assembly is easy, and in an assembling process, only the internal magnet needs to be fastened in the first shell or the second shell, and then the second shell and the second shell are fastened to each other.

The first shell and the second shell may be of a same structure. A connection between the first shell and the second shell may be planar connection, and the first shell and the second shell are connected and fastened by using glue. Advantages of this solution are: The first shell and the second shell do not need to be distinguished in a process of assembling the composite magnetic core, and because the first shell and the second shell are of the same structure, efficiency is high in an assembling and fastening process. In another implementation, the connection between the first shell and the second shell may be connected in a concave-convex coordination manner, or the first shell and the second shell are mutually coordinated and connected by using a step structure.

Or, also according to the invention as claimed, the first shell includes a first wall and a second wall that is bent and extended from an edge of the first wall, the second shell includes a third wall and a fourth wall that is bent and extended from an edge of the third wall, the first wall and the third wall are disposed opposite to each other, the second wall and the fourth wall are disposed opposite to each other, the first shell and the second shell are connected to form accommodating space of different sizes, and the accommodating space is used to accommodate the internal magnet. In this solution, an application range of the external magnetic shell is improved. One external magnetic shell may match internal magnets of different sizes, to form composite magnetic cores of different models. In addition, the external magnetic shell and the internal magnet in the composite magnetic core provided in this solution may be seamlessly connected, and the internal magnet is jointly located by using an inner surface of the first shell and an inner surface of the second shell. Another fastening medium is not needed between the internal magnet and the external magnetic shell, for example, glue does not need to be dispensed between the internal magnet and the external magnetic shell. In this solution, a volume of the composite magnetic core can be reduced, and this is conducive to a design of a small size of the magnetic element.

In a possible implementation, the external magnetic shell is of an annular structure and forms annular accommodating space used for accommodating the internal magnet, the external magnetic shell includes an inner wall and an outer wall that are stacked in a radial direction, the inner wall forms a through hole, the composite magnetic core further includes a magnetic sheet, the magnetic sheet is located in the through hole and is connected to the inner wall, and the magnetic sheet separates the through hole into two sub-holes. The magnetic sheet has a magnetic conduction function, and can increase differential-mode inductance. Specifically, in the magnetic element, air passes through a differential-mode magnetic path, and magnetic permeability of the air is 1. In this solution, the magnetic sheet is added, and magnetic permeability of the magnetic sheet is far greater than that of air, and the magnetic permeability of the magnetic sheet may reach tens to several thousand. Magnetic sheets of different materials have different magnetic permeability. Because the magnetic sheet is disposed in the through hole in this application, it may be understood as that a part of the air is replaced by the magnetic sheet, so that the inductance is increased. Therefore, in this solution, the differential-mode inductance can be increased.

In a possible implementation, a material of the magnetic sheet is the same as that of the external magnetic shell.

In a possible implementation, the magnetic sheet and the external magnetic shell are in an integrated structure.

In a possible implementation, the magnetic sheet and the external magnetic shell are in a separated structure.

In a possible implementation, the magnetic sheet is entirely accommodated inside the through hole.

In a possible implementation, thickness of the magnetic sheet is greater than or equal to 1 mm. In this solution, the thickness of the magnetic sheet is limited to be greater than 1 mm, so that a relatively good effect of increasing common-mode inductance can be implemented.

In a possible implementation, thickness of the magnetic sheet is the same as thickness of the external magnetic shell, and the thickness of the external magnetic shell is greater than or equal to 1 mm.

In a possible implementation, the magnetic sheet may be a rigid material. In this solution, thickness of the magnetic sheet may be set to be relatively thick, and may be specifically greater than or equal to 1 mm, to ensure that magnetic permeability of the magnetic sheet can meet a filtering requirement of the magnetic element.

In a possible implementation, the magnetic sheet may alternatively be a flexible sheet material. In this solution, thickness of the magnetic sheet may be relatively thin, for example, is less than 1 mm, and the magnetic sheet may be bent and extended in the through hole. A volume occupied by the magnetic sheet in the through hole is set based on a size of the winding and a size of the through hole by using a characteristic that the flexible sheet material is easily bent. In this way, a volume occupied by the magnetic sheet may be as large as possible, to obtain relatively large common-mode inductance.

In a possible implementation, the magnetic element is a common-mode inductor, and may be a two-phase common-mode inductor or a three-phase common-mode inductor.

According to a second aspect, an implementation of this application provides an electronic device, including a circuit board and the magnetic element provided in any one of the possible implementations of the first aspect. The magnetic element is disposed on the circuit board, and the winding is electrically connected to the circuit board.

### BRIEF DESCRIPTION OF DRAWINGS

To describe technical solutions in embodiments of this application or in the background more clearly, the following describes the accompanying drawings used in embodiments of this application or in the background.
FIG. 1 is a schematic diagram of an electronic device according to an implementation of this application;
FIG. 2 is a schematic diagram of a magnetic element according to an implementation of this application;
FIG. 3 is a schematic three-dimensional decomposed diagram of the magnetic element shown in FIG. 2;
FIG. 4 is a schematic diagram of structures of an external magnetic shell and a magnetic sheet in a composite magnetic core in a magnetic element according to an implementation of this application;
FIG. 5 is a schematic three-dimensional decomposed diagram of an external magnetic shell in a composite magnetic core in a magnetic element according to an implementation of this application;
FIG. 6 is a schematic diagram of a cross section of an external magnetic shell in a composite magnetic core in a magnetic element according to an implementation of this application;
FIG. 7 is a schematic diagram of a state in which an internal magnet is mounted inside the external magnetic shell shown in FIG. 6;
FIG. 8 is a schematic three-dimensional decomposed diagram of an external magnetic shell in a composite magnetic core in a magnetic element according to an implementation of this application;
FIG. 9 is a schematic diagram of a cross section in a state in which an internal magnet is mounted inside the external magnetic shell in the composite magnetic core in the magnetic element shown in FIG. 8;
FIG. 10 is a schematic diagram of a cross section in another state in which an internal magnet is mounted inside the external magnetic shell in the composite magnetic core in the magnetic element shown in FIG. 8; and
FIG. 11 is a schematic three-dimensional decomposed diagram of an external magnetic shell in a composite magnetic core in a magnetic element according to an implementation of this application.

### DESCRIPTION OF EMBODIMENTS

The following describes embodiments of this application with reference to the accompanying drawings in embodiments of this application.

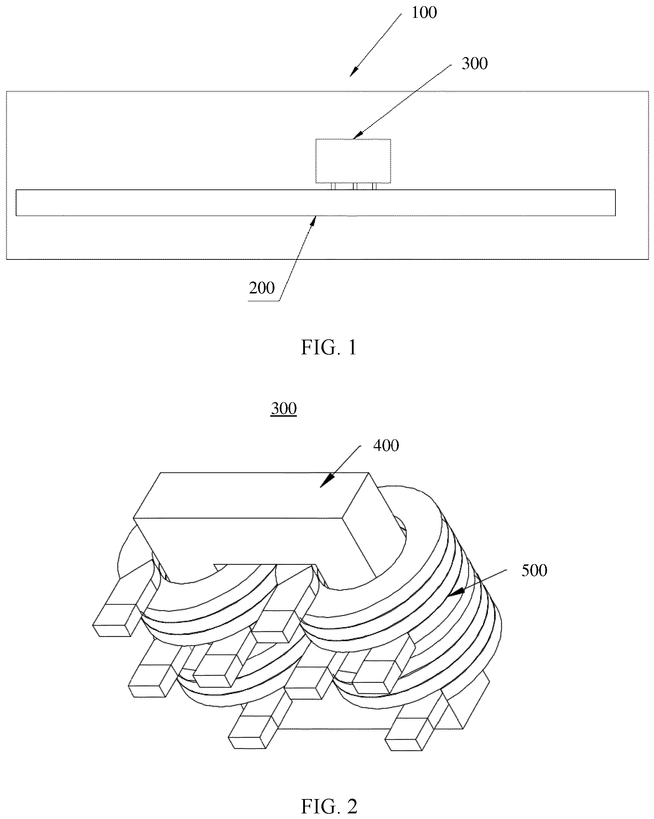

As shown in FIG. 1, a circuit board 200 is disposed in an electronic device 100 provided in a specific implementation of this application, and a magnetic element 300 is disposed on the circuit board 200. The magnetic element 300 may be a common-mode inductor, and plays a role of EMI filtering to suppress outward radiation of an electromagnetic wave generated by a high-speed signal cable in the electronic device. Specifically, the electronic device 100 may be a computer, a router, another communication device, a terminal device, or the like, or the electronic device 100 may be a mobile phone, a tablet computer, a vehicle-mounted computer, an intelligent wearable product, or the like. A specific type of the electronic device is not specifically limited in this embodiment of this application, and the electronic device needs to be a device with the magnetic element. Specifically, a switch-mode power supply circuit is disposed in the electronic device 100. The magnetic element 300 provided in this application may be disposed in the switch-mode power supply circuit to filter a common-mode electromagnetic interference signal. The magnetic element 300 may be a two-phase common-mode inductor, or may be a three-phase common-mode inductor. Specifically, a winding of the magnetic element 300 is electrically connected to the circuit board 200.

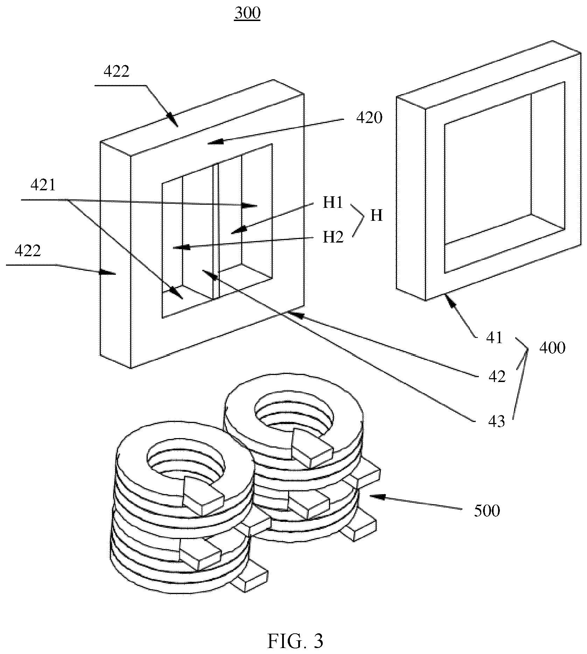

A two-phase common-mode inductor is used as an example for description. In a specific implementation, as shown in FIG. 2 and FIG. 3, the magnetic element 300 includes a composite magnetic core 400 and a winding 500, and the winding 500 is wound around the composite magnetic core 400. The winding 500 is a coil, and the winding 500 may be formed by winding an enameled copper wire. The enameled copper wire includes a round wire and a flat wire. A material of the winding is not limited in this application. The composite magnetic core 400 includes an internal magnet 41 and an external magnetic shell 42. The external magnetic shell 42 partially or entirely covers a periphery of the internal magnet 41.

The internal magnet 41 is formed by winding a strip material. Specifically, the strip material of the internal magnet 41 in the composite magnetic core 400 provided in this application may be a nanocrystalline material or an amorphous strip material, and the internal magnet 41 may be made by a winder. For the internal magnet formed by winding the strip material, a coil cannot be directly wound on an outer surface of the internal magnet, because pulling stress acting on a surface of the internal magnet 41 may be generated in a process of winding the coil, and the stress may destroy the internal magnet 41 and affect a filtering function of the magnetic element 300. Therefore, a protective structure needs to be disposed on the outer surface of the internal magnet 41. Because the external magnetic shell 42 in the composite magnetic core 400 provided in this application has a magnetic material, as a protective shell covering the periphery of the internal magnet 41, the external magnetic shell 42 can not only protect the internal magnet 41 from pulling stress in a wire winding process, but also increase common-mode impedance of the composite magnetic core 400 and improve the filtering function of the magnetic element 300. Specifically, the external magnetic shell 42 covers the periphery of the internal magnet 41 and is fixedly connected to the internal magnet 41, and the external magnetic shell 42 may protect the internal magnet 41. The external magnetic shell 42 in the composite magnetic core 400 provided in this application has the magnetic material, the winding 500 is wound on an outer surface of the external magnetic shell 42, and the external magnetic shell 42 has a function of filtering electromagnetic noise. Therefore, the composite magnetic core 400 provided in this application can improve a filtering effect of the magnetic element 300. If the external magnetic shell 42 has no magnetic material, but has only a function of protecting the internal magnet 41, and the external magnetic shell 42 is made of a non-magnetic material, such an external magnetic shell 42 in the composite magnetic core 400 cannot participate in the filtering function of the magnetic element 300. If the external magnetic shell 42 occupies space of the composite magnetic core 400 but has no filtering function, this is not conducive to a miniaturization design of the composite magnetic core 400, and consequently, a volume and costs of a component (that is, the magnetic element 300) are increased.

In an implementation, a material of the external magnetic shell 42 is ferrite. In an implementation, the material of the external magnetic shell 42 is alloy magnetic powder (which may also be understood as an alloy powder magnet). Specifically, the external magnetic shell 42 may be a combination of manganese zinc ferrite, nickel zinc ferrite, and alloy magnetic powder. If the non-magnetic material is replaced with a magnetic material, common-mode impedance of the magnetic element 300 can be increased, and this is conducive to miniaturization and costs reduction of the magnetic element 300. For a magnetic element in a conventional technology, for an electromagnetic wave signal of 100 kHz, common-mode impedance of the magnetic element is 2000 Ω. For the magnetic element 300 provided in this application, if ferrite whose magnetic permeability is 7000 is used as a solution of a nanocrystalline protective shell whose magnetic permeability is 30000, that is, the material of the external magnetic shell 42 is ferrite whose magnetic permeability is 7000, and a material of the internal magnet 41 is nanocrystalline whose magnetic permeability is 30000, for an electromagnetic wave signal of 100 kHz, common-mode impedance of the magnetic element 300 is 4060 Ω. It can be learned that, in a same size, a filtering effect of the magnetic element 300 provided in this application is significantly improved.

In an implementation, a material of the internal magnet 41 in the composite magnetic core 400 is a nanocrystalline strip material, and a material of the external magnetic shell 42 in the composite magnetic core 400 is ferrite. In this solution, performance of a common-mode inductor of the magnetic element 300 can be improved, and a volume and costs of the magnetic element 300 can be reduced. Specifically, in this solution, the material of the internal magnet and the material of the external magnetic shell are limited, and the internal magnet of the nanocrystalline strip material and the external magnetic shell of the ferrite are combined in one composite magnetic core, so that performance of a common-mode inductor can be improved while a volume and costs of the composite magnetic core are properly controlled. In this way, not only the magnetic element has a relatively good filtering effect, but overall performance of the magnetic element can also be improved in a design condition that a relatively small volume and relatively low costs are controlled.

In an implementation, a material of the internal magnet 41 in the composite magnetic core 400 is a nanocrystalline strip material, and a material of the external magnetic shell 42 in the composite magnetic core 400 is a combination of manganese zinc ferrite, nickel zinc ferrite, and alloy magnetic powder. In this solution, the material of the internal magnet and the material of the external magnetic shell are limited, and the internal magnet of the nanocrystalline strip material matches the external magnetic shell made of the combined material, so that wideband (150 kHz to 300 MHz) filtering can be implemented. In other words, in this solution, a frequency range of an electromagnetic filtering signal filtered by the magnetic element 300 is relatively wide, and may be 150 kHz to 300 MHz. In this solution, the volume and the costs of the magnetic element 300 can also be reduced. A filtering range of a magnetic element in a conventional technology is (150 kHz to 30 MHz, or 30 MHz to 300 MHz). Compared with the conventional technology, filtering bandwidth is widened in this application.

As shown in FIG. 2 and FIG. 3, in an implementation, the external magnetic shell 42 is of an annular structure and forms annular accommodating space 420 used for accommodating the internal magnet 41 (a reference numeral 420 in FIG. 3 means space enclosed inside the external magnetic shell 42, and the external magnetic shell 42 is a hollow structure). Specifically, an outer contour of the annular structure formed by the external magnetic shell 42 is square, and an inner contour is also square. The internal magnet 41 and the external magnetic shell have similar structure forms but different sizes. The internal magnet 41 may be mounted inside the external magnetic shell 42 and surrounded by the external magnetic shell 42. The external magnetic shell 42 includes an inner wall 421 and an outer wall 422 that are stacked in a radial direction, and the inner wall 421 forms a through hole H. The composite magnetic core 400 further includes a magnetic sheet 43, and the magnetic sheet 43 is located in the through hole H and is connected to the inner wall 421. In an implementation, the composite magnetic core 400 is applied to a two-phase common-mode inductor, there are two groups of windings 500, and there is one magnetic sheet 43. The magnetic sheet 43 separates the two groups of windings 500 (as shown in FIG. 2), and the magnetic sheet 43 separates the through hole H into two sub-holes H1 and H2. One sub-hole H1 is used to accommodate one group of windings 500, and the other sub-hole H2 is used to accommodate the other group of windings 500. In this implementation, the magnetic sheet 43 is disposed in the through hole H enclosed by the external magnetic shell 42, and the magnetic sheet 43 has a magnetic conduction function, and can increase differential-mode inductance. Specifically, in the magnetic element, air passes through a differential-mode magnetic path, and magnetic permeability of the air is 1. In this solution, the magnetic sheet 43 is added, and magnetic permeability of the magnetic sheet 43 is far greater than that of air, and the magnetic permeability of the magnetic sheet 43 may reach tens to several thousand. Magnetic sheets 43 of different materials have different magnetic permeability. Because the magnetic sheet 43 is disposed in the through hole H in this application, it may be understood as that a part of the air is replaced by the magnetic sheet 43, so that the inductance is increased. Therefore, in this solution, the differential-mode inductance can be increased.

A material of the magnetic sheet 43 may be the same as the material of the external magnetic shell 42. This solution facilitates a manufacturing process of the external magnetic shell 42 and the magnetic sheet 43. The magnetic sheet 43 and the external magnetic shell 42 may be in an integrated structure. The material of the magnetic sheet 43 may alternatively be different from the material of the external magnetic shell. The magnetic sheet 43 and the external magnetic shell 42 may be designed as a separated structure. For example, the magnetic sheet 43 and the external magnetic shell 42 may be directly fixedly connected through cooperation of a buckle and a slot, or may be connected by using another conversion bracket. A specific position of the magnetic sheet 43 in the through hole H may be adjusted in a separated design, to adjust filtering performance of the magnetic element 300.

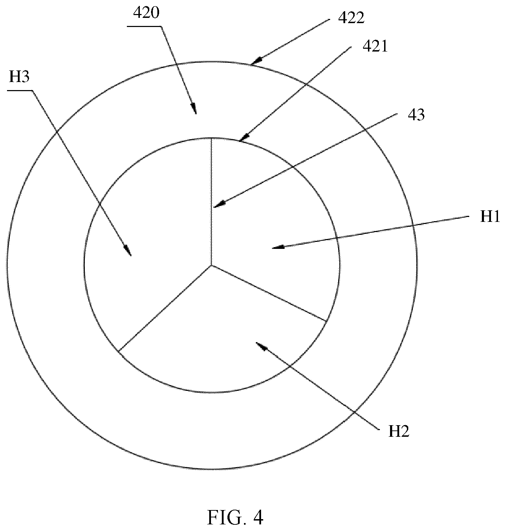

In another implementation, as shown in FIG. 4, the composite magnetic core 400 is applied to a three-phase common-mode inductor, there are three groups of windings 500, there are three magnetic sheets 43, and the magnetic sheets 43 separate the through hole H into three sub-holes H1, H2, and H3. The three sub-holes H1, H2, and H3 are separately used to accommodate different windings. In this implementation, alternatively, there is one magnetic sheet 43. A form of the magnetic sheet 43 is different from a form shown in FIG. 3. The magnetic sheet 43 is non-straight or non-plate-shaped, and may have a plurality of branches, for example, three branches, and edges of the three branches are fastened together, and an included angle between two branches is 120 degrees. In this way, the through hole may be divided into three sub-holes H1, H2, and H3 by one magnetic sheet 43. In FIG. 4, the inner wall 421, the outer wall 422, and the magnetic sheet 43 are schematically represented by using lines. In an actual product, structures represented by these lines have specific thickness, and are entity structures. An edge of the magnetic sheet 43 is fixedly connected to an outer surface of the inner wall 421.

Specifically, the edge of the magnetic sheet 43 may not exceed a boundary of the through hole H; in other words, the magnetic sheet 43 is entirely accommodated in the through hole H. This solution helps implement a connection between the magnetic sheet 43 and the external magnetic shell 42, and facilitates manufacture and winding. In another implementation, an outer contour of the magnetic sheet 43 may alternatively exceed a boundary of the through hole H, and may be implemented in the magnetic element 300. An orthogonal projection of the winding on the magnetic sheet 43 falls within the magnetic sheet 43. In this solution, a clearer effect of increasing the differential-mode inductance is implemented. Certainly, an area of an orthogonal projection of the winding in a plane in which the magnetic sheet 43 is located may also be greater than an area of the magnetic sheet 43.

In an implementation, thickness of the magnetic sheet 43 is greater than or equal to 1 mm. In this solution, the thickness of the magnetic sheet is limited to be greater than 1 mm, so that a relatively good effect of increasing common-mode inductance can be implemented.

In an implementation, thickness of the magnetic sheet 43 is the same as thickness of the external magnetic shell 42, and the thickness of the external magnetic shell 42 is greater than or equal to 1 mm.

In an implementation, the magnetic sheet 43 may be a rigid material. In this solution, thickness of the magnetic sheet 43 may be set to be relatively thick, and may be specifically greater than or equal to 1 mm, to ensure that magnetic permeability of the magnetic sheet 43 can meet a filtering requirement of the magnetic element.

In an implementation, the magnetic sheet 43 may alternatively be a flexible sheet material. In this solution, thickness of the magnetic sheet 43 may be relatively thin, for example, is less than 1 mm, and the magnetic sheet 43 may be bent and extended in the through hole H. A volume occupied by the magnetic sheet 43 in the through hole H is set based on a size of the winding and a size of the through hole H by using a characteristic that the flexible sheet material is easily bent. In this way, a volume occupied by the magnetic sheet 43 may be as large as possible, to obtain relatively large common-mode inductance.

The external magnetic shell 42 in the composite magnetic core 400 provided in this application may be an integrated structure, and is formed on the outer surface of the internal magnet 41 through packaging or coating. For example, the external magnetic shell 42 may be formed on the outer surface of the internal magnet 41 through spraying or electroplating, or the external magnetic shell 42 may be fabricated on the outer surface of the internal magnet 41 by using an integrated injection molding process. The external magnetic shell 42 may be in an entirely closed structure without any gap (or air gap). In another implementation, a gap (or an air gap) may alternatively be disposed on the external magnetic shell 42, magnetism of the composite magnetic core is adjusted by disposing the gap (or the air gap), and a filtering effect of the magnetic element 300 is controlled.

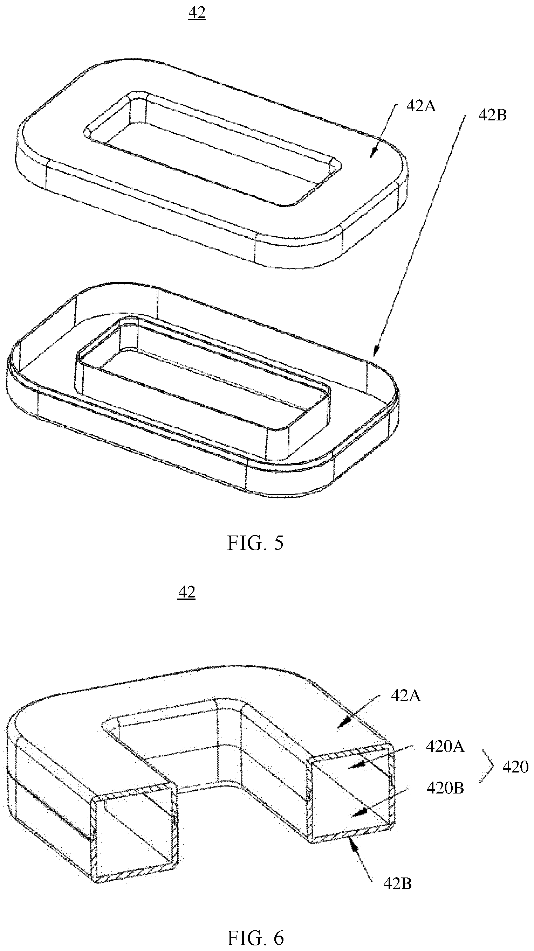

As shown in FIG. 5, FIG. 6, and FIG. 7, in another implementation, the external magnetic shell 42 may alternatively be a separated structure. For example, the external magnetic shell 42 includes a first shell 42A and a second shell 42B, and the first shell 42Aand the second shell 42B are connected to jointly surround the internal magnet 41.

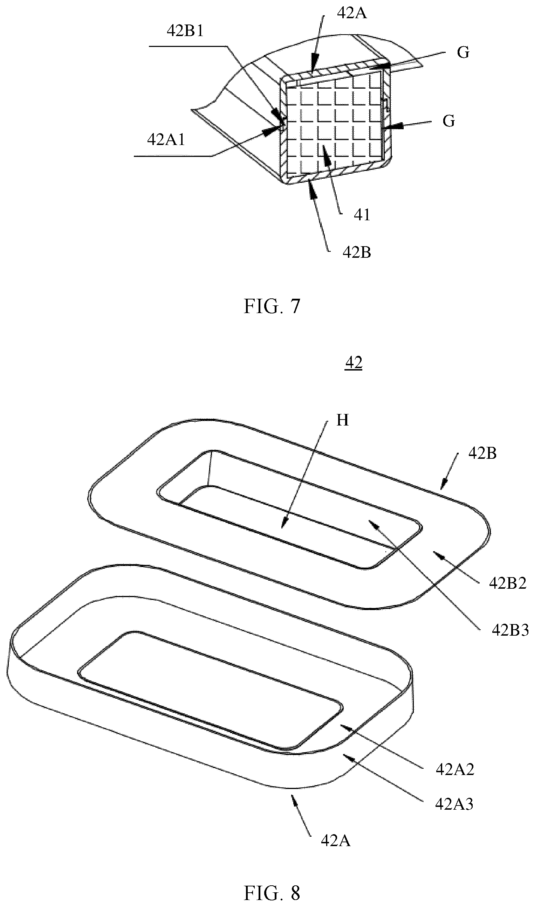

The first shell 42A and the second shell 42B are connected or fastened to each other to form the external magnetic shell 42, the first shell 42A forms first space 420A, the second shell 42B forms second space 420B, the first space 420A and the second space 420B are connected to form accommodating space 420, and the internal magnet 41 is jointly accommodated, and a gap G is disposed between the internal magnet 41 and an inner surface of the external magnetic shell 42. The internal magnet 41 and the inner surface of the external magnetic shell 42 may be fastened by an adhesive. As shown in FIG. 7, two adjacent surfaces of the internal magnet 41 are bonded to and fixedly connected to the inner surface of the external magnetic shell 42. A gap G may exist between the inner surface of the external magnetic shell 42 and the other two surfaces of the internal magnet 41. Because there is a tolerance between the internal magnet 41 and the external magnetic shell 42 in a processing and assembling process, or a planeness problem is caused due to a processing procedure of the outer surface of the internal magnet 41 and the inner surface of the external magnetic shell 42, the internal magnet 41 and the external magnetic shell 42 cannot be entirely bonded in a contact process, and consequently, sizes of the internal magnet 41 and the external magnetic shell 42 do not entirely match each other (when the sizes of the internal magnet 41 and the external magnetic shell 42 entirely match each other, the outer surface of the internal magnet 41 may be entirely bonded to the external magnetic shell 42). In this condition, there is the gap G between the internal magnet 41 and the external magnetic shell 42, but the gap G does not affect normal working of the composite magnetic core 400.

In an implementation, the first shell 42A and the second shell 42B may be of a same structure. A connection between the first shell 42A and the second shell 42B may be planar connection, and the first shell 42A and the second shell 42B are connected and fastened by using glue. Advantages of this solution are: The first shell 42A and the second shell 42B do not need to be distinguished in a process of assembling the composite magnetic core, and because the first shell 42A and the second shell 42B are of the same structure, efficiency is high in an assembling and fastening process. In another implementation, the connection between the first shell 42A and the second shell 42B may be connected in a concave-convex coordination manner, or the first shell 42A and the second shell 42B are mutually coordinated and connected by using a step structure. In an implementation shown in FIG. 5 to FIG. 7, a connection surface between the first shell 42A and the second shell 42B includes an L-shaped surface or a Z-shaped surface. This connection manner helps improve a sealing effect at the connection between the first shell 42A and the second shell 42B. Specifically, the first shell 42A includes a first connection part 42A1, the second shell 42B includes a second connection part 42B1, and a connection surface of the first shell 42A and the second shell 42B is a surface in which the first connection part 42A1 and the second connection part 42B 1 are in contact with each other. A direction extending from the inner surface of the external magnetic shell 42 to the outer surface of the external magnetic shell 42 is a radial direction. In the radial direction, the first connection part 42A1 and the second connection part 42B 1 are stacked. In this implementation, the first connection part 42A1 is disposed around a periphery of the second connection part 42B1, and the first connection part 42A1 and the second connection part 42B1 may be connected and sealed by using glue.

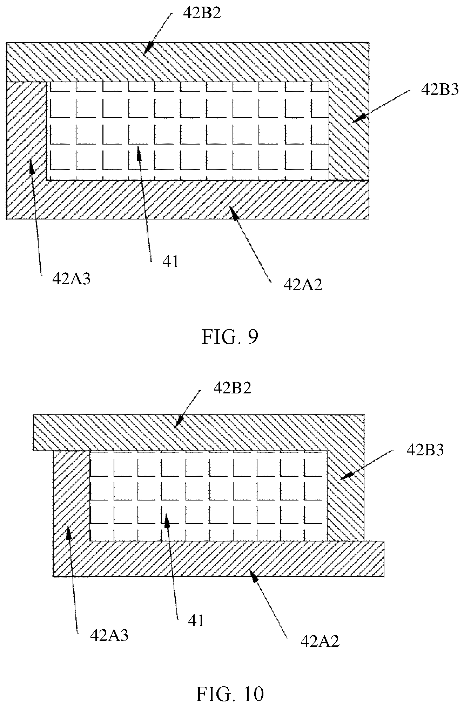

In an implementation, after being connected, the first shell 42A and the second shell 42B may form accommodating space 420 of different sizes. As shown in FIG. 8, FIG. 9, and FIG. 10, the first shell 42A includes a first wall 42A2 and a second wall 42A3 that is bent and extended from an edge of the first wall 42A2, the second shell 42B includes a third wall 42B2 and a fourth wall 42B3 that is bent and extended from an edge of the third wall 42B2, the first wall 42A2 and the third wall 42B2 are disposed opposite to each other, the second wall 42A3 and the fourth wall 42B3 are disposed opposite to each other, the first shell 42A and the second shell 42B are connected to form accommodating space of different sizes, and the accommodating space is used to accommodate the internal magnet 41. As shown in FIG. 9, the external magnetic shell 42 and the internal magnet 41 in the composite magnetic core 400 provided in this solution may be seamlessly connected, and the internal magnet 41 is jointly located by using an inner surface of the first shell 42A and an inner surface of the second shell 42B. Another fastening medium is not needed between the internal magnet 41 and the external magnetic shell 42, for example, glue does not need to be dispensed between the internal magnet 41 and the external magnetic shell 42. In this way, a volume of the composite magnetic core 400 can be reduced, and this is conducive to a design of a small size of the magnetic element 300. With reference to FIG. 9 and FIG. 10, a size of the internal magnet 41 in the solution shown in FIG. 10 is less than a size of the internal magnet 41 in the solution shown in FIG. 9. For the external magnetic shell 42, when a position at which the first shell 42A and the second shell 42B are connected is different, a size of the accommodating space inside the external magnetic shell 42 can be adjusted. Therefore, the external magnetic shell 42 provided in this solution can match internal magnets 41 of more sizes, to form a plurality of composite magnetic cores 400 of different sizes, and is widely applied.

In the implementation shown in FIG. 8, the first wall 42A2 of the first shell 42A and the third wall 42B2 of the second shell 42B form a top wall and a bottom wall of the external magnetic shell 42, and the first wall 42A2 and the third wall 42B2 may be the same in shapes and sizes. Both the first wall 42A2 and the third wall 42B2 may be of a flat plate-shaped structure, and both the first wall 42A2 and the third wall 42B2 may alternatively be of an arcuate plate-shaped structure. The second wall 42A3 of the first shell 42A forms an outer wall of the external magnetic shell 42, the fourth wall 42B3 of the second shell 42B forms an inner wall of the external magnetic shell 42, the fourth wall 42B3 forms the through hole H of the external magnetic shell 42, the second wall 42A3 is located on a periphery of the fourth wall 42B3, and an area between the second wall 42A3 and the fourth wall 42B3 is an annular area. An inner contour and an outer contour of the annular area may be square, circular, or another shape, and the internal magnet 41 is accommodated in the annular area.

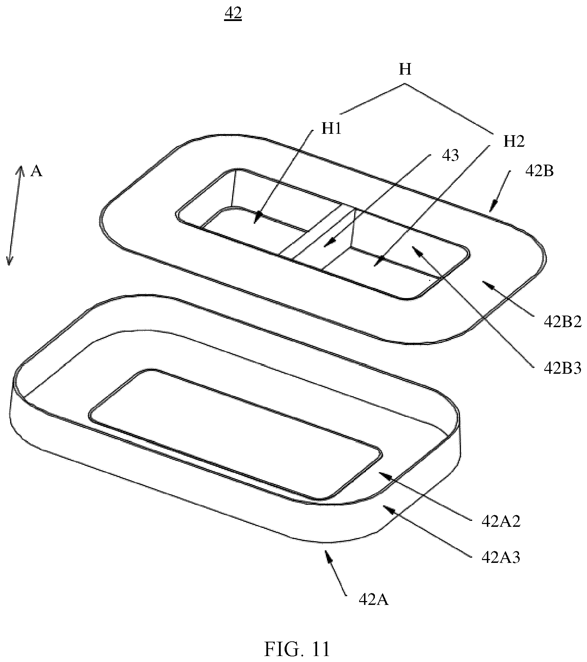

In an implementation, as shown in FIG. 11, the external magnetic shell 42 includes a first shell 42A and a second shell 42B. A structure of the first shell 42A is the same as that in the implementation shown in FIG. 8. A structure of the second shell 42B is different from that in the implementation shown in FIG. 8 in that the second shell 42B includes a magnetic sheet 43. In this implementation, the magnetic sheet 43 is a flat plate-shaped structure, two opposite ends of the magnetic sheet 43 are connected to a fourth wall 42B3 of the second shell 42B, and the magnetic sheet 43 separates a through hole H formed by the fourth wall 42B3 into two sub-holes H1 and H2. In another implementation, the magnetic sheet 43 may alternatively be arcuate plate-shaped.

In the implementation shown in FIG. 11, a first wall 42A2 of the first shell 42A and a third wall 42B2 of the second shell 42B are disposed at intervals in a first direction A, and a size of the magnetic sheet 43 in the first direction A may be less than or equal to a vertical distance between an outer surface of the first wall 42A2 and an outer surface of the third wall 42B2. It may also be understood as that a top surface of the magnetic sheet 43 is flush with the outer surface of the first wall 42A2, and a bottom surface of the magnetic sheet 43 is flush with the outer surface of the third wall 42B2. The outer surface of the first wall 42A2 is a surface that is of the first wall 42A2 and that is away from the third wall 42B2, and the outer surface of the third wall 42B2 is a surface that is of the third wall 42B2 that is away from the first wall 42A2.

The external magnetic shell 42 provided in the foregoing embodiment entirely covers the internal magnet 41, to provide full protection for the internal magnet 41. In another implementation, the external magnetic shell 42 may alternatively partially cover the internal magnet 41, and covers only a part of the internal magnet 41 corresponding to the winding. For example, as shown in FIG. 2 and FIG. 3, in this implementation, the composite magnetic core 400 is approximately rectangular in shape, and includes four magnetic pillars, and two magnetic pillars are opposite to each other. The winding 500 is wound around left and right magnetic pillars, and no winding is disposed on peripheries of upper and lower magnetic pillars. Based on this case, the external magnetic shell 42 may be disposed only on peripheries of the left and right magnetic pillars, and no external magnetic shell may be disposed at positions of the upper and lower magnetic pillars. The external magnetic shell can protect the internal magnet and increase the common-mode impedance of the magnetic element provided that the winding is wound on the external magnetic shell.

The foregoing embodiments are merely intended for describing the technical solutions of this application, but not for limiting this application. Although this application is described in detail with reference to the foregoing embodiments, a person of ordinary skill in the art should understand that modifications to the technical solutions recorded in the foregoing embodiments or equivalent replacements to some technical features thereof may still be made.

## Claims

1. A magnetic element (300), used in an electronic device (100) and configured to suppress outward radiation of an electromagnetic wave generated by a high-speed signal cable in the electronic device (100), wherein the magnetic element (300) comprises a composite magnetic core (400) and a winding (500), the composite magnetic core (400) comprises an internal magnet (41) and an external magnetic shell (42), the internal magnet (41) is formed by winding a strip material, the external magnetic shell (42) partially or entirely covers a periphery of the internal magnet (41), the external magnetic shell (42) is fixedly connected to the internal magnet (41), the winding (500) is wound on an outer surface of the external magnetic shell (42), the external magnetic shell (42) is configured to protect the internal magnet (41) from pulling force in a process of winding the winding (500), and the external magnetic shell (42) is configured to increase common-mode impedance of the magnetic element (300),
wherein the external magnetic shell (42) comprises a first shell (42A) and a second shell (42B), and the first shell (42A) and the second shell (42B) are connected and jointly surround the internal magnet (41); and
wherein
the first shell (42A) forms first space (420A), the second shell (42B) forms second space (420B), the first space (420A) and the second space (420B) are connected to each other and jointly accommodate the internal magnet (41), and a gap (G) is disposed between the internal magnet (41) and an inner surface of the external magnetic shell (42), or
the first shell (42A) comprises a first wall (42A2) and a second wall (42A3) that is bent and extended from an edge of the first wall (42A2), the second shell (42B) comprises a third wall (42B2) and a fourth wall (42B3) that is bent and extended from an edge of the third wall (42B2), the first wall (42A2) and the third wall (42B2) are disposed opposite to each other, the second wall (42A3) and the fourth wall (42B3) are disposed opposite to each other, the first shell (42A) and the second shell (42B) are connected to form accommodating space of different sizes, and the accommodating space (420) is used to accommodate the internal magnet (41).

2. The magnetic element (300) according to claim 1, wherein a material of the external magnetic shell (42) comprises at least one of ferrite or alloy magnetic powder.

3. The magnetic element (300) according to claim 1 or 2, wherein a material of the internal magnet (41) comprises at least one of amorphous alloy or nanocrystalline.

4. The magnetic element (300) according to claim 1, wherein a material of the internal magnet (41) is a nanocrystalline strip material, and a material of the external magnetic shell (42) is ferrite.

5. The magnetic element (300) according to claim 1, wherein a material of the internal magnet (41) is a nanocrystalline strip material, and a material of the external magnetic shell (42) is a combination of manganese zinc ferrite, nickel zinc ferrite, and alloy magnetic powder.

6. The magnetic element (300) according to any one of claims 1 to 5, wherein the external magnetic shell (42) is of an annular structure and forms annular accommodating space (420) used for accommodating the internal magnet (41), the external magnetic shell (42) comprises an inner wall (421) and an outer wall (422) that are stacked in a radial direction, the inner wall (421) forms a through hole (H), the composite magnetic core (400) further comprises a magnetic sheet (43), the magnetic sheet (43) is located in the through hole (H) and is connected to the inner wall (421), and the magnetic sheet (43) separates the through hole (H) into two or three sub-holes (H1, H2, H3).

7. The magnetic element (300) according to claim 6, wherein a material of the magnetic sheet (43) is the same as that of the external magnetic shell (42).

8. The magnetic element (300) according to claim 6 or 7, wherein the magnetic sheet (43) and the external magnetic shell (42) are in an integrated structure.

9. The magnetic element (300) according to claim 6 or 7, wherein the magnetic sheet (43) and the external magnetic shell (42) are in a separated structure.

10. The magnetic element (300) according to any one of claims 6 to 9, wherein the magnetic sheet (43) is entirely accommodated inside the through hole (H).

11. An electronic device (100), comprising a circuit board (200) and the magnetic element (300) according to any one of claims 1 to 10, wherein the magnetic element (300) is disposed on the circuit board (200), and the winding (500) is electrically connected to the circuit board (200).

## Patentansprüche

1. Magnetelement (300), das in einer elektronischen Vorrichtung (100) verwendet wird und konfiguriert ist, um eine ausgehende Strahlung einer elektromagnetischen Welle, die durch ein Hochgeschwindigkeitssignalkabel in der elektronischen Vorrichtung (100) erzeugt wird, zu unterdrücken, wobei das Magnetelement (300) einen Verbundmagnetkern (400) und eine Wicklung (500) umfasst, der Verbundmagnetkern (400) einen internen Magneten (41) und eine externe Magnethülle (42) umfasst, der interne Magnet (41) durch Wickeln eines Bandmaterials ausgebildet ist, die externe Magnethülle (42) einen Umfang des internen Magneten (41) teilweise oder vollständig bedeckt, die externe Magnethülle (42) mit dem internen Magneten (41) fest verbunden ist, die Wicklung (500) auf eine Außenoberfläche der externen Magnethülle (42) gewickelt ist, die externe Magnethülle (42) konfiguriert ist, um den internen Magneten (41) vor einer Zugkraft in einem Prozess des Wickelns der Wicklung (500) zu schützen und die externe Magnethülle (42) konfiguriert ist, um eine Gleichtaktimpedanz des Magnetelements (300) zu erhöhen,
wobei die externe Magnethülle (42) eine erste Hülle (42A) und eine zweite Hülle (42B) umfasst und die erste Hülle (42A) und die zweite Hülle (42B) verbunden sind und den internen Magneten (41) gemeinsam umgeben; und
wobei
die erste Hülle (42A) den ersten Raum (420A) ausbildet, die zweite Hülle (42B) einen zweiten Raum (420B) ausbildet, der erste Raum (420A) und der zweite Raum (420B) miteinander verbunden sind und gemeinsam den internen Magnet (41) aufnehmen und ein Spalt (G) zwischen dem internen Magneten (41) und einer Innenoberfläche der externen Magnethülle (42) angeordnet ist, oder
die erste Hülle (42A) eine erste Wand (42A2) und eine zweite Wand (42A3), die von einer Kante der ersten Wand (42A2) abgewinkelt ist und sich von dieser erstreckt, umfasst, die zweite Hülle (42B) eine dritte Wand (42B2) und eine vierte Wand (42B3), die von einer Kante der dritten Wand (42B2) abgewinkelt ist und sich von dieser erstreckt, umfasst, die erste Wand (42A2) und die dritte Wand (42B2) einander gegenüberliegend angeordnet sind, die zweite Wand (42A3) und die vierte Wand (42B3) einander gegenüberliegend angeordnet sind, die erste Hülle (42A) und die zweite Hülle (42B) verbunden sind, um einen Aufnahmeraum unterschiedlicher Größe auszubilden und der Aufnahmeraum (420) verwendet wird, um den internen Magneten (41) aufzunehmen.

2. Magnetelement (300) nach Anspruch 1, wobei ein Material der externen Magnethülle (42) mindestens eines von Ferrit oder magnetischem Legierungspulver umfasst.

3. Magnetelement (300) nach Anspruch 1 oder 2, wobei ein Material des internen Magneten (41) mindestens eines von amorpher Legierung oder nanokristallinem Material umfasst.

4. Magnetelement (300) nach Anspruch 1, wobei ein Material des internen Magneten (41) ein nanokristallines Bandmaterial ist und ein Material der externen Magnethülle (42) Ferrit ist.

5. Magnetelement (300) nach Anspruch 1, wobei ein Material des internen Magneten (41) ein nanokristallines Bandmaterial ist und ein Material der externen Magnethülle (42) eine Kombination aus Mangan-Zink-Ferrit, Nickel-Zink-Ferrit und magnetischem Legierungspulver ist.

6. Magnetelement (300) nach einem der Ansprüche 1 bis 5, wobei die externe Magnethülle (42) von einer ringförmigen Struktur ist und einen ringförmigen Aufnahmeraum (420) ausbildet, der zum Aufnehmen des internen Magneten (41) verwendet wird, die externe Magnethülle (42) eine Innenwand (421) und eine Außenwand (422) umfasst, die in einer radialen Richtung gestapelt sind, die Innenwand (421) ein Durchgangsloch (H) ausbildet, der Verbundmagnetkern (400) ferner einen Magnetbogen (43) umfasst, sich der Magnetbogen (43) in dem Durchgangsloch (H) befindet und mit der Innenwand (421) verbunden ist und der Magnetbogen (43) das Durchgangsloch (H) in zwei oder drei Teillöcher (H1, H2, H3) trennt.

7. Magnetelement (300) nach Anspruch 6, wobei ein Material des Magnetbogens (43) das gleiche wie das der externen Magnethülle (42) ist.

8. Magnetelement (300) nach Anspruch 6 oder 7, wobei der Magnetbogen (43) und die externe Magnethülle (42) in einer integrierten Struktur vorliegen.

9. Magnetelement (300) nach Anspruch 6 oder 7, wobei der Magnetbogen (43) und die externe Magnethülle (42) in einer getrennten Struktur vorliegen.

10. Magnetelement (300) nach einem der Ansprüche 6 bis 9, wobei der Magnetbogen (43) vollständig innerhalb des Durchgangslochs (H) aufgenommen ist.

11. Elektronische Vorrichtung (100), die eine Leiterplatte (200) und das Magnetelement (300) nach einem der Ansprüche 1 bis 10 umfasst, wobei das Magnetelement (300) auf der Leiterplatte (200) angeordnet ist und die Wicklung (500) mit der Leiterplatte (200) elektrisch verbunden ist.

## Revendications

1. Élément magnétique (300), utilisé dans un dispositif électronique (100) et configuré pour supprimer un rayonnement vers l'extérieur d'une onde électromagnétique générée par un câble de signal à grande vitesse dans le dispositif électronique (100), dans lequel l'élément magnétique (300) comprend un noyau magnétique composite (400) et un enroulement (500), le noyau magnétique composite (400) comprend un aimant interne (41) et une coque magnétique externe (42), l'aimant interne (41) est formé en enroulant un matériau de bande, la coque magnétique externe (42) couvre partiellement ou entièrement une périphérie de l'aimant interne (41), la coque magnétique externe (42) est reliée de manière fixe à l'aimant interne (41), l'enroulement (500) est enroulé sur une surface externe de la coque magnétique externe (42), la coque magnétique externe (42) est conçue pour protéger l'aimant interne (41) d'une force de traction lors d'un processus d'enroulement de l'enroulement (500), et la coque magnétique externe (42) est conçue pour augmenter l'impédance de mode commun de l'élément magnétique (300),
dans lequel la coque magnétique externe (42) comprend une première coque (42A) et une seconde coque (42B), et la première coque (42A) et la seconde coque (42B) sont reliées et entourent conjointement l'aimant interne (41) ; et
dans lequel
la première coque (42A) forme un premier espace (420A), la seconde coque (42B) forme un second espace (420B), le premier espace (420A) et le second espace (420B) sont reliés l'un à l'autre et logent conjointement l'aimant interne (41), et un interstice (G) est disposé entre l'aimant interne (41) et une surface interne de la coque magnétique externe (42), ou
la première coque (42A) comprend une première paroi (42A2) et une deuxième paroi (42A3) qui est pliée et étendue à partir d'un bord de la première paroi (42A2), la seconde coque (42B) comprend une troisième paroi (42B2) et une quatrième paroi (42B3) qui est pliée et étendue à partir d'un bord de la troisième paroi (42B2), la première paroi (42A2) et la troisième paroi (42B2) sont disposées à l'opposé l'une de l'autre, la deuxième paroi (42A3) et la quatrième paroi (42B3) sont disposées à l'opposé l'une de l'autre, la première coque (42A) et la seconde coque (42B) sont reliées pour former un espace de logement de tailles différentes, et l'espace de logement (420) est utilisé pour loger l'aimant interne (41).

2. Élément magnétique (300) selon la revendication 1, dans lequel un matériau de la coque magnétique externe (42) comprend au moins l'un parmi de la ferrite ou de la poudre magnétique d'alliage.

3. Élément magnétique (300) selon la revendication 1 ou 2, dans lequel un matériau de l'aimant interne (41) comprend au moins l'un parmi un alliage amorphe ou un matériau nanocristallin.

4. Élément magnétique (300) selon la revendication 1, dans lequel un matériau de l'aimant interne (41) est un matériau de bande nanocristallin, et un matériau de la coque magnétique externe (42) est de la ferrite.

5. Élément magnétique (300) selon la revendication 1, dans lequel un matériau de l'aimant interne (41) est un matériau de bande nanocristallin, et un matériau de la coque magnétique externe (42) est une combinaison de ferrite de manganèse-zinc, de ferrite de nickel-zinc et de poudre magnétique d'alliage.

6. Élément magnétique (300) selon l'une quelconque des revendications 1 à 5, dans lequel la coque magnétique externe (42) a une structure annulaire et forme un espace de logement annulaire (420) utilisé pour loger l'aimant interne (41), la coque magnétique externe (42) comprend une paroi interne (421) et une paroi externe (422) qui sont empilées dans une direction radiale, la paroi interne (421) forme un trou traversant (H), le noyau magnétique composite (400) comprend en outre une feuille magnétique (43), la feuille magnétique (43) est située dans le trou traversant (H) et est reliée à la paroi interne (421), et la feuille magnétique (43) sépare le trou traversant (H) en deux ou trois sous-trous (H1, H2, H3).

7. Élément magnétique (300) selon la revendication 6, dans lequel un matériau de la feuille magnétique (43) est le même que celui de la coque magnétique externe (42).

8. Élément magnétique (300) selon la revendication 6 ou 7, dans lequel la feuille magnétique (43) et la coque magnétique externe (42) sont dans une structure intégrée.

9. Élément magnétique (300) selon la revendication 6 ou 7, dans lequel la feuille magnétique (43) et la coque magnétique externe (42) sont dans une structure séparée.

10. Élément magnétique (300) selon l'une quelconque des revendications 6 à 9, dans lequel la feuille magnétique (43) est entièrement logée à l'intérieur du trou traversant (H).

11. Dispositif électronique (100), comprenant une carte de circuit imprimé (200) et l'élément magnétique (300) selon l'une quelconque des revendications 1 à 10, dans lequel l'élément magnétique (300) est disposé sur la carte de circuit imprimé (200), et l'enroulement (500) est connecté électriquement à la carte de circuit imprimé (200).
